Europäisches Patentamt

European Patent Office

Office européen des brevets

(19)

(11) **EP 0 457 749 B1**

(12) **EUROPÄISCHE PATENTSCHRIFT**

(45) Veröffentlichungstag und Bekanntmachung des Hinweises auf die Patenterteilung:
**10.09.1997 Patentblatt 1997/37**

(51) Int Cl.6: **H03M 1/50**, H03M 1/60, H03M 3/02

(21) Anmeldenummer: **91890082.0**

(22) Anmeldetag: **19.04.1991**

(54) **Hochgenauer Analog-Digital-Umsetzer nach dem Ladungsausgleichverfahren**

High-accuracy charge-balance analog-digital converter

Convertisseur analogique-numérique à équilibrage de charge, de haute précision

(84) Benannte Vertragsstaaten:
**AT BE CH DE DK ES FR GB GR IT LI LU NL SE**

(30) Priorität: **19.04.1990 EP 90890123**

(43) Veröffentlichungstag der Anmeldung:
**21.11.1991 Patentblatt 1991/47**

(73) Patentinhaber: **AUSTRIA MIKRO SYSTEME INTERNATIONAL AKTIENGESELLSCHAFT A-8141 Unterpremstätten (AT)**

(72) Erfinder:
• **Leopold, Hans, Dr. A-8043 Graz (AT)**
• **O'Leary, Paul A-8010 Graz (AT)**

(74) Vertreter: **Gibler, Ferdinand, Dipl.Ing. Dr. techn. Dorotheergasse 7/14 1010 Wien (AT)**

(56) Entgegenhaltungen:
EP-A- 0 367 522          US-A- 3 942 172

• **Electronic Analog-Digital Converters, Wiley & Sons, 1983, Seiten 64-67**
• **Analog Devices Conversion Products Catalog, 1977, Seiten 199-201**

**Beschreibung**

Die Erfindung betrifft einen hochgenauen Analog-Digital-Umsetzer nach dem Ladungsausgleichverfahren mit einem Spannungseingang, einem Differenzintegrator und einer Ladungsausgleichsregelschleife.

Für hochauflösende und hochgenaue Analog-Digital-Umsetzer sind verschiedene Konzepte bekannt; als wesentliche Verfahren sind Wägekonverter, algorithmische Konverter und mittelwertbildende Umsetzer zu nennen.

Aus der US-PS-3 942 172 ist ein Analog-Digital-Umsetzer bekanntgeworden, der einen als Summier-Integrator geschalteten Operationsverstärker umfaßt, dessen invertierender Eingang über einen Widerstand mit dem zu wandelnden Signal verbunden ist und zugleich einen Summiereingang bildet, welcher einerseits über einen Rampen-Kondensator und einen Widerstand mit einem Takt-Rechteckgenerator verbunden ist und andererseits über Schalttransistoren und einen Vorwiderstand an eine positive oder negative Referenzspannungsquelle oder auf Masse schaltbar ist. Der Ausgang des Integrators ist mit zwei Schwellwertkomparatoren mit negativer und positiver Schwellwertspannung verbunden, deren Ausgänge wiederum jeweils mit dem Eingang je eines getakteten Flipflops verbunden sind. Die Ausgänge der Flipflops sind mit einer Auswerteschaltung zur Bestimmung des Tastverhältnisses verbunden und steuern über einen Rückführzweig zugleich die Schalttransistoren und somit das Potential am Vorwiderstand. Über die Bestimmung des Tastverhältnisses wird die Digitalisierung der analogen Eingangsspannung durchgeführt.

Weiters offenbart die EP-A2-0 367 522 einen Analog-Digital-Umsetzer für kleine Pegel und niedrige Frequenzen, bei dem der Ausgang eines Summier-Integrators über einen Komparator mit einem Pulsbreitenmodulator verbunden ist, wobei der zweite Komparatoreingang mit einer Rampenspannung beaufschlagt ist und der Ausgang des Pulsbreitenmodulators an den Eingang des Integrators rückgeführt ist. Dabei wird entsprechend dem Tastverhältnis der Ausgangsspannung des Pulsbreitenmodulators über einen Referenzspannungswähler eine positive oder eine negative Referenzspannung während einer Integrationsperiode an den Eingang des Integrators gelegt. Die Periode des die Rampenspannung erzeugenden Rampengenerators ist durch die durch einen Frequenzteiler geteilte Taktfrequenz des Systemtaktgebers bestimmt. Der Divisor $2^N$ des Frequenzteilers bestimmt dabei die Auflösung.

In der Druckschrift "Electronic Analog-Digital-Converters, Wiley & Sons 1983" ist auf den S. 64 bis 67 ein Analog-Digital-Umsetzer gezeigt, welcher an seinem Eingang einen Komparator aufweist, dessen Referenzeingang mit einer Referenzspannungsquelle und dessen Vergleichseingang einerseits mit einem Kondensator, der über eine Stromquelle mit dem umzusetzenden Strom geladen wird, und andererseits über einen steuerbaren Schalter mit zwei Referenzstromquellen mit entgegengesetzter Stromrichtung verbunden ist. Der Ausgang des Komparators ist mit dem Eingang eines getakteten Flipflops verbunden, welches an seinem Ausgang das quantisierte Ausgangssignal des Analog-Digital-Umsetzers liefert, mit welchem auch der steuerbare Schalter gesteuert wird. Dieser Schalter wird dabei so gesteuert, daß die Spannung am Kondensator immer am nächstmöglichen Wert zur Komparatorreferenzspannung liegt. Die Differenz der Anzahl der Schaltstellungen, in denen ein positiver bzw. negativer Referenzstrom zusätzlich zum Eingangsstrom den Kondensator lädt bzw. entlädt in einer durch den Systemtakt bestimmten Zeitspanne entspricht dem umzusetzenden Eingangsstrom. Die Auflösung ist dabei durch die Länge dieser Zeitspanne bestimmt.

Der Nachteil der herkömmlichen Konzepte liegt darin, daß sie Merkmale aufweisen, welche der Herstellung in kostengünstiger, monolithisch integrierter Form entgegenstehen.

Die Forderungen an ein Konzept für einen hochgenauen, monolithisch integrierten Analog-Digital-Umsetzer können dabei wie folgt zusammengefaßt werden:

1)

Da die Toleranzen integrierter elektronischer Bauelemente in der Größenordnung 1% und mehr liegen (und außerdem noch die Alterung und der Temperatureinfluß Auswirkungen auf die Genauigkeit haben), die Genauigkeit des Analog-Digital-Umsetzers aber zum Beispiel $10^{-6}$ relativ zur Referenzspannung betragen soll, dürfen die Werte der Bauelemente nicht (auch nicht als Verhältnis) in der Übertragungsfunktion des Analog-Digital-Umsetzer aufscheinen. Erst wenn diese Forderung erfüllt ist, ist Justage bei der Fertigung vermeidbar und die Genauigkeit auf Lebensdauer gegeben. Außerdem ist nur ein solches System wirtschaftlich prüfbar. Wäre die Genauigkeit nicht durch die Architektur des Analog-Digital-Umsetzer gewährleistet, so müßten bei einem 20 bit Analog-Digital-Umsetzer $10^6$ Messungen durchgeführt werden, um auch nur jeden Ausgangskode zu prüfen.

2)

Die Schaltung soll für positive Eingangsspannungen ohne negative Referenzspannung auskommen, sie soll nur eine Betriebsspannung benötigen und die Betriebsspannung soll als Referenzspannung verwendbar sein. Trotzdem soll der Meßbereich für die Einangsspannung den Wert 0 einschließen.

3)

Die Stromaufnahme des Analog-Digital-Umsetzer soll klein (etwa in der Größenordnung Milliampere) sein, damit keine unzulässigen Wärmeströmungen am Chip entstehen, die transiente Fehler hervorrufen können. Stationäre Fehler sind bei Erfüllung der ersten Forderung ausgeschlossen.

4)

Niederohmige Verbindungen zwischen den Bauelementen (wie sie auf Leiterplatten im Bereich von Milliohm üblich sind) dürfen keine Voraussetzung für die Funktion oder die Genauigkeit des ADU sein. Wenn zwei Widerstände gleich groß sein sollen, muß ein Unterschied der Widerstandswerte in der Größenordnung von 1 Ohm ausreichend klein sein.

5)

Auf einer Leiterplatte (in einem nichtmonolithischen Aufbau)kann das Verhältnis der vom Schaltungsentwerfer vorgesehenen Kapazitätswerte zu jenen der unvermeidlichen parasitären Koppelkapazitäten zwischen Punkten der Schaltung, die nicht verkoppelt sein sollten, beliebig groß gemacht werden. Auf einem monolithischen Schaltkreis ist dieses Verhältnis beschränkt, sodaß mit kapazitivem Übersprechen aus dem Digitalteil des Umsetzers und/oder einem nicht zum Analog-Digital-Umsetzer gehörigen Digitalsystem auf demselben Chip zu rechnen ist. Jede digitale Schaltflanke injiziert sowohl in den Meßals auch in den Referenzstromkreis des ADU eine bestimmte elektrische Ladung, deren Betrag von der Höhe der Flanke mal dem Betrag der Koppelkapazität, deren Vorzeichen von der Richtung der Flanke (Übergang von High nach Low bzw umgekehrt) bestimmt wird. Es kann daher trotz großer und undefinierter kapazitiver Störbeeinflussung nur ein Analog-Digital-Umsetzer zufriedenstellend funktionieren, der den linearen Zeitmittelwert der Meßgröße und jenen des aus der Referenzgröße abgeleiteten Referenzsignals bildet, weil ganz sicher ist, daß in jedem Digitalsystem, das zweiwertige Variable verwendet, auf eine positive Flanke eine negative Flanke und umgekehrt folgen muß. Ein den linearen Mittelwert bildendes System mittelt den Störstrom aus den einzelnen Ladungspaketen alternierenden Vorzeichens zu Null.

Alle Analog-Digital-Umsetzer-Verfahren, bei denen die Gewichtung der Signale im Verlauf der Umsetzung veränderlich ist, verfügen nicht über diese Toleranz gegenüber kapazitiven Störkopplungen auf dem monolithischen Schaltkreis.

Aus obengenannten Gründen scheiden daher sowohl das Wägeverfahren (sukzessive Approximation) als auch der algorithmische Konverter als Kanditaten für hochauflösende, hochgenaue monolithisch integrierte Analog-Digital-Umsetzer aus, obwohl beide mit Hilfe des Schalter-Kondensatorprinzips (SC=switched capacitor) unabhängig von Bauteilwerten gemacht werden können.

6)

Eine weitere Forderung betrifft die Vermeidung von analogen Abtast- und Haltegliedern (sample and hold circuit). Für eine angenommene Genauigkeit von 20 bit sind monolithisch integrierte Abtast- und Halteglieder (unter anderem wegen der unvermeidlichen dielektrischen Absorption im Haltekondensator) nicht praktikabel. Dies stellt ein weiteres zwingendes Argument für eine den linearen Zeitmittelwert des Meßsignals bildende Analog-Digital-Umsetzer-Eingangsstruktur dar. Die für die digitale Darstellung einer zeitveränderlichen Größe notwendige Abtastung muß daher nach erfolgter Diskretisierung bzw. Quantisierung im digitalen Raum vorgenommen werden. Die analoge Eingangsstruktur des Analog-Digital-Umsetzers kann diese Diskretisierung bzw. Quantisierung vornehmen, indem sie das kontinuierliche Verhältnis der Meßspannung zur Referenzspannung in das Tastverhältnis eines zweiwertigen, zeitdiskreten Referenzsignals abbildet. Diese Abbildung ist aber nur dann korrekt möglich, wenn der (theoretisch) unendlich große Informationsgehalt des kontinuierlichen Eingangssignals durch zeitliche Mittelwertbildung auf mindestens jenen des zeitdiskreten Referenzsignals reduziert wird.

Entsprechend dem Stand der Technik kann die Abbildung so vorgenommen werden, daß durch einen getakteten Pulsbreitenmodulator, der die Zeitdiskretisierung durchführt, ein zweiwertiges Signal (das Referenzsignal) mit den Werten Null Volt und Referenzspannung (dies entspricht der Wertdiskretisierung) generiert wird, dessen Spannungs-Zeitfläche in einer Regelschleife jener des Meßsignals laufend angeglichen wird. Diese Schleife enthält einen Integrator zur Bildung der Spannungs-Zeitflächen gleichbedeutend den zeitlichen Mittelwerten. Da diese Schleife ununterbrochen für bestmögliche Gleichheit der Zeitmittel von Meßsignal und Referenzsignal sorgt, kann über beliebige Zeitintervalle hinweg digital weiter gemittelt werden. Damit ist auch die Auflösung eines nach diesem Verfahren arbeitenden AnaLOG_Digital-Umsetzer im digitalen Raum frei wählbar. Dies stellt einen bedeutenden Vorteil für die digitale Signalverarbeitung etwa durch Signalprozessoren dar.

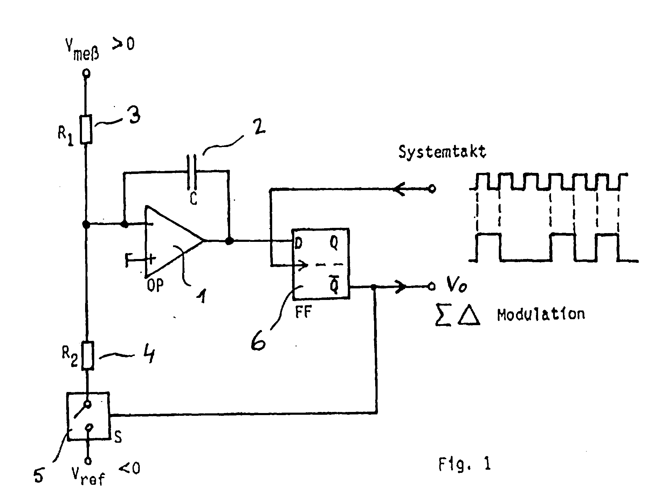

Eine bekannte Schaltungsanordnung, die die genannte Abbildung vornimmt, ist der in Fig.1 gezeigte Sigma-Delta-Modulator. Dieser liefert ein zeitdiskretes Logiksignal, dessen Tastverhältnis das Verhältnis der Zeitmittelwerte der Meßspannung zur Referenzspannung wiedergibt. In jeder Periode des Systemtakts hat dieses Signal das Gewicht Null oder Eins. Man kann daher formal die ganze Regelschleife als Pulsbreitenmodulator auffassen, der nur zwei Werte der Pulsbreite erzeugen kann, nämlich Null (Pulsdauer Null) oder Eins (entspricht einer Pulsdauer gleich der Periodendauer des Systemtaktes).

Für eine Auflösung von n bit benötigt der Sigma-Delta-Modulator daher 2 hoch n Perioden des Systemtaktes.

Von Nachteil ist weiters, daß das Verhältnis zweier Widerstände R1 und R2 das Übertragungsmaß des Analog-Digital-Umsetzer bestimmt und darüberhinaus die Referenzspannung eine der Meßspannung entgegengesetzte Polarität aufweisen muß.

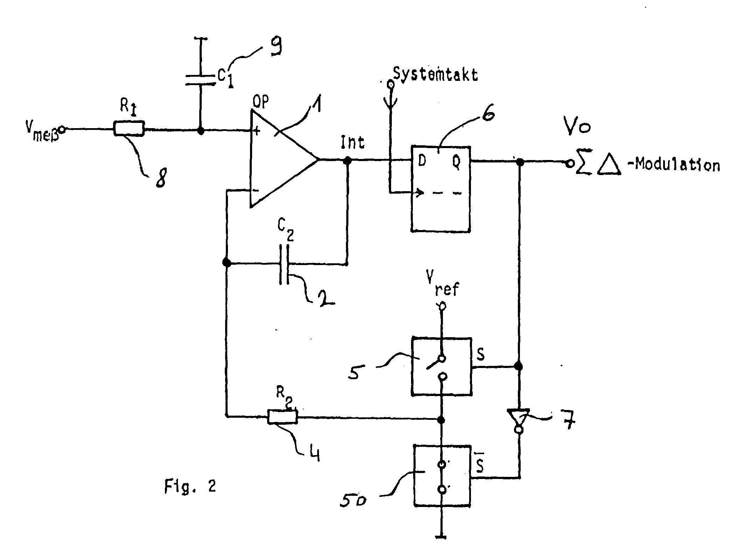

Eine andere bekannte Topologie des Integrators, nämlich die des Differenzintegrators entsprechend der Fig. 2 weist die beiden letztgenannten Nachteile nicht auf.

Der Operationsverstärker bildet an seinem Ausgang die Differenz der Zeitintegrale von Meßspannung und der mit dem Tastverhältnis des Ausgangssignals modulierten Referenzspannung (Referenzsignal) in der Spannungsdomäne. Die Werte der beiden Kondensatoren C1, C2 und der beiden Widerstände R1, R2 gehen in die Übertragungsfunktion für den Mittelwert der Meßspannung nicht ein. Meßspannung und Referenzspannung haben dasselbe Vorzeichen. Die Schaltung hat einen echten Spannungseingang-nicht einen Spannungs-zu-Stromwandler wie die in Fig.1 gezeigte Anordnung.

Auch alle anderen angeführten Forderungen sind von diesem Konzept erfüllbar. trotzdem ist dieses Konzept in der herkömmlichen Form für einen integrierten hochauflösenden Analog-Digital-Umsetzer kaum brauchbar.

Bezüglich der Arbeitsweise des vom Systemtakt gesteuerten Flip-Flops unterscheiden sich die beiden Anordnungen nämlich nicht voneinander: Für eine Auflösung von 20 bit wären etwa $10^6$ Perioden des Systemtakts erforderlich. Dementsprechend hoch wird auch die Zahl der Schaltspiele der beiden Schalter S und $\bar{S}$. Da mit jedem Schaltspielpaar ein bestimmter Zeitfehler zwangsweise verbunden ist (in der gegenwärtigen monolithischen CMOS-Technik etwa Ins), müßte die Periode des Systemtakts zu etwa $10^6$ ns = 1ms gewählt werden um 20 bit Genauigkeit zu erreichen. Da aber für 20 bit Auflösung etwa 1 Million Systemtakt-Perioden lang gemessen werden muß, ist die daraus resultierende Konversionszeit (1000 s) auch für einen 20 bit Analog-Digital-Umsetzer eindeutig zu lange.

Bei Verkürzung der Periode des Systemtakts und festem Zeitfehler entsteht ein nichtlinearer sehr störender Fehler, weil die Zahl der Schalterspiele bei kleiner Meßspannung erst ansteigt, beim Meßwert entsprechend der halben Referenzspannung ihren Höchstwert erreicht und dann wieder fällt, bis sie für den Meßwert gleich der Referenzspannung wieder zu Null wird.

Aufgabe der Erfindung ist es daher, ein Schaltungskonzept für einen hochgenauen Analog-Digital-Umsetzer der eingangs genannten Art anzugeben, das die obengenannten Forderungen erfüllt, sodaß der Analog-Digital-Umsetzer in monolithisch integrierter Technik ausgeführt werden kann und eine wesentlich kürzere Konversionszeit aufweist.

Dies wird erfindungsgemäß dadurch erreicht, daß im Vorwärtszweig der Regelschleife ein von einem Systemtakt gesteuerter und vom Ausgang des Differenzintegrators beaufschlagter Pulsbreitenmodulator vorgesehen ist, daß das vom Pulsbreitenmodulator erzeugte, zum Differenzintegrator rückgeführte Signal ein systemtaktfrequentes Pulssignal ist, welches als Pulsdauer ein ganzzahliges Vielfaches der Periodendauer eines Übertaktes aufweist und daß der Analog-Digital-Umsetzer zumindest im Ausmaß sämtlicher aktiver elektronischer Bauelemente monolithisch integrierbar bzw. monolithisch integriert ist.

Das FlipFlop der herkömmlichen Konzepte wird durch einen (nicht mehr entarteten) Pulsbreitenmodulator ersetzt, der von einem zB 1000 oder $10^4$ mal schnelleren Übertakt getaktet wird. Dieser Pulsbreitenmodulator wird vom Ausgangssignal des Integrators so gesteuert, daß er eine von 1000 oder $10^4$ möglichen, diskreten Pulsbreiten in jeder Periode des Systemtaktes abgibt. Da nun in einer Periode des Systemtaktes der Entscheidungsgehalt 1000 oder $10^4$ enthalten ist, werden für 20 bit Auflösung nur mehr 1000 oder 100 Perioden des Systemtaktes benötigt. Da es pro Periode des Systemtaktes nur ein Schaltspielpaar mit einem wie vorhin zu ca. 1 ns angenommenen Zeitfehler gibt, kann diese Periode für 20 bit Genauigkeit nach wie vor 1 ms betragen. Die Konversionszeit für 20 bit Auflösung beträgt weiterhin $10^6$ Perioden des Übertaktes jedoch verkürzt sich die Konversionszeit auf 1s oder 0.1s.

Eine Verbesserung der Underdrückung von Einkopplungen der eigenen digitalen Systemteile wird dadurch erreicht, daß der Systemtakt aus dem Übertakt durch Frequenzteilung erzeugt wird.

Die Einführung eines Pulsbreitenmodulators in das System erhöht die Genauigkeit des Analog-Digital-Umsetzer in einer zweiten Weise:

Der Integratorausgang in der herkömmlichen Schaltung nach Fig.2 muß für jedes Schaltspielpaar die logische Schwelle des D-Eingangs des FlipFlops über- und unterschreiten. Dies bedeutet bei sehr vielen Schaltspielen in kurzer Zeit, daß die Zeitkonstante R2*C2 sehr klein und der Operationsverstärker sehr schnell sein müßte. Durch die Verwendung des Pulsbreitenmodulator braucht der Integratorausgang nur wie ein quasistatischer Zeiger auf eine bestimmte Steuerspannung am Eingang C des Pulsbreitenmodulator für eine bestimmte Pulsbreite (oder die ihr unmittelbar benachbarte) hinzuweisen. Erst diese Tatsache erlaubt die Ausnützung der quasistatischen Genauigkeit des Operationsverstärkers, die dann sehr groß gemacht werden kann, wenn der Operationsverstärker des Ladungsausgleichintegrators automatischen Nullpunktabgleich bzw. Chopperstabilisierung aufweist. Bei einer Betriebsspannung von 5 V beträgt ein Spannungsinkrement bei 20 bit Auflösung 5 µV und die notwendige Gleichtaktunterdrückung des Operationsverstärkers 130 dB. Das ist mit einem solchen Operationsverstärker im quasistatischen Betrieb erreichbar.

Eine weitere Genauigkeitssteigerung ist dadurch erreichbar,daß der Operationsverstärker im Ladungsausgleichsintegrator Feldeffekttransistoren in der Eingangsstufe aufweist. Die MOS-Eingangsstufen erreichen Eingangsströme im Bereich einiger Pikoampere, welche es erlauben die Widerstände R1 und besonders R2 so groß zu machen, daß die notwendige Übereinstimmung der Einschaltwiderstände der beiden Schalter 5, 50 bezogen auf den Widerstand R2 auch im Standard CMOS-Prozeß gegeben ist.

Eine weitere Verbesserung ergibt sich, wenn das im Pulsbreitenmodulator erzeugte Rampensignal den Wertebereich von Null bis zur Referenzspannung Vref des Analog-Digital-Umsetzer umfaßt. Die Spannung am Eingang C des Pulsbreitenmodulator wird dann ungefähr gleich groß wie die Meßspannung. Dies bedeutet, daß die mittlere Spannung am Integrationskondensator C2 angenähert 0 Volt unabhängig von der Meßspannung bleibt. Dieser Umstand reduziert den Einfluß der unvermeidlichen dielektrischen Absorption im Integrationskondensator C2 beträchtlich, was der Verwendung eines integrierten Kondensators C2 entgegenkommt.

Die Erfindung ist nicht auf die zwingende Integration von C2 bzw. R2 beschränkt; je nach Fortschritt bzw. Stand der CMOS Technik bzw. des unbedingt erforderlichen Genauigkeitsgrades kann C2 und/oder R2 monolithisch integriert oder als externes Bauelement realisiert sein. Wesentlich für die Erfindung ist, daß zumindest sämtliche aktive elektronische Bauelemente des Analog-Digital-Umsetzers monolithisch integrierbar bzw. monolithisch integriert sind.

Die Ausgestaltung des erfindungsgemäßen Analog-Digital-Umsetzer erlaubt es, daß der Analog-Digital-Umsetzer von einer einzigen Betriebsspannung versorgt wird. Hiedurch wird insbesondere der Vorteil erreicht, daß die vollständige monolithische Integration des Analog- wie des Digitalteils in CMOS-Technik möglich ist.

Nachstehend ist die Erfindung anhand der Zeichnungen beispielsweise erläutert.

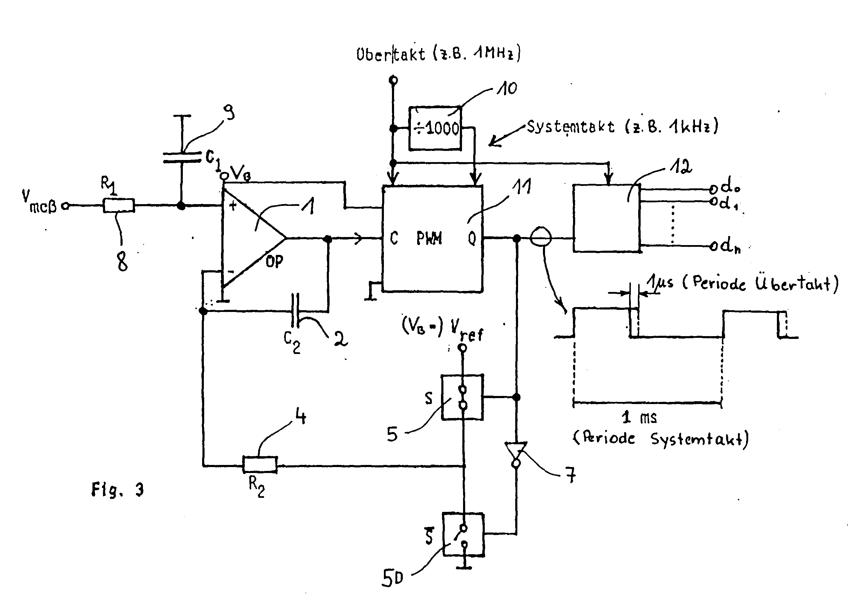

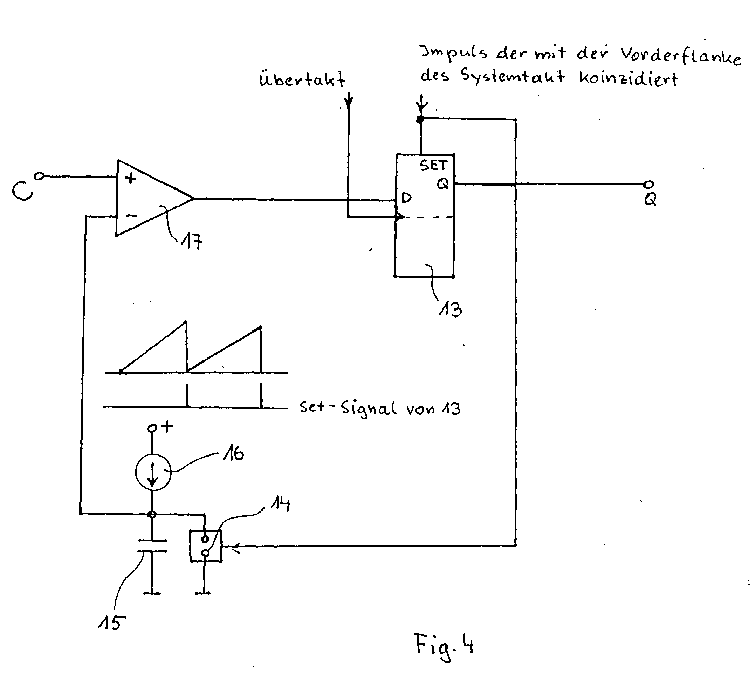

Es zeigt die Fig.1 einen Sigma-Delta-Modulator, die Fig.2 einen Sigma-Delta-Modulator mit Differenzintegrator. Die Fig.3 zeigt eine beispielhafte Ausgestaltung eines erfindungsgemäßen Analog-Digital-Umsetzers, wobei die Fig.4 eine mögliche Ausführungsform des Pulsbreitenmodulators für einen Analog-Digital-Umsetzer entsprechend der Fig.3 darstellt.

Der Analog-Digital-Umsetzer nach dem Ladungsausgleichsverfahren gemäß Fig.1 weist einen Ladungsausgleichsintegrator auf, der aus einem Operationsverstärker 1, einem zwischen dem Ausgang des Operationsverstärkers und dem Summationspunkt angeordneten Integrationskondensator 2 und den mit einem Ende an dem Summationspunkt angeschlossenen Skalierungswiderständen R1 (3) und R2 (4) besteht. Der Ausgang des Operationsverstärkers 12 ist an den Dateneingang eines D-Flip-Flops 6 geführt, das von einem Systemtakt getaktet wird. Der invertierende Ausgang $\overline{Q}$

des Flip-Flops 6 stellt das Ausgangssignal des Umsetzers dar und steuert einen elektronisch steuerbaren Schalter 5, über welchen an das zweite Ende des Skalierungswiderstandes R2 (4) eine negative Referenzspannung Vref anlegbar ist.

Die am zweiten Ende des Skalierungswiderstandes R1 (3) anliegende positive Meßspannung Vmeß treibt einen ihr proportionalen Strom in den Integrationskondensator C (2). Dadurch sinkt die Spannung am Integratorausgang bis die logische Schwelle am Dateneingang D des Flip-Flops 6 unterschritten wird. Zur nächsten signifikanten Flanke des Systemtakts ändert das Flip-Flop seinen Zustand und schließt damit den Schalter 5. Nun treibt die Referenzspannung einen negativen Strom, dessen Betrag größer als der größte Meßstrom sein muß, zusätzlich in den Integrationskondensator 2 und kehrt somit die Richtung der Rampe am Integratorausgang um. Nachdem die logische Schwelle überschritten ist, kippt das FlipFlop bei der nächsten signifikanten Flanke. Die durch den Integrator, das FlipFlop und den steuerbaren Schalter gebildete Regelschleife sorgt dafür, daß der Mittelwert der anden Summationspunkt gelieferten Ladung Null wird. Werden während m Systemtaktperioden k Perioden gezählt, in denen das zweiwertige Ausgangssignal des Umsetzters Vo den Zustand High aufweist (also der Schalter 5 geschlossen ist), so gilt:

$$\frac{Vme\beta}{R1} + \frac{k}{m} * \frac{Vref}{R2} = 0$$

$$k = - m * \frac{Vme\beta}{Vref} * \frac{R2}{R1}$$

Die Auflösung eines derartigen Delta-Sigma-Konverters hängt von der Größe m ab (m = 2 hoch Auflösung in bit). Die Zahl der Schalterspiele pro Konversion ist sehr groß und hängt nichtlinear von k ab.

Die Fig.2 zeigt einen Delta-Sigma-Umsetzer mit einem Differenzintegrator. Der Differenzintegrator, gebildet aus dem Operationsverstärker 1 und dem zwischen dem Ausgang des Operationsverstärkers und dem invertierenden Eingang angeordneten Integrationskondensator C2 (2), wird an seinem nichtinvertierenden Eingang von der Eingangsspannung Vmeß beaufschlagt, wobei gegebenenfalls ein Tiefpaßfilter bestehend aus einem Serienwiderstand R1 (8) und einem Parallelkondensator C1 (9) als Anti-Aliasing-Filter zwischengeschaltet sein kann. Der Ausgang des Operationsverstärkers ist an den Dateneingang D des FlipFlops 6 geführt, das vom Systemtakt getaktet wird und an seinem Ausgang Q das Ausgangssignal Vo des Umsetzers liefert. Der Ausgang des FlipFlops 6 ist weiters direkt mit dem Steuereingang eines ersten elektronisch steuerbaren Schalters 5 und über einen Inverter 7 mit dem eines zweiten Schalters 50 verbunden. Über die beiden mit ihren Schalterstrecken in Serie liegenden und an der Referenzzspannung Vref bzw an dem Bezugspotential anliegenden und komplementär zueinander geschalteten Schalter wird an ein Ende eines Widerstandes R2 (4) die mit dem Tastverhältnis des Ausgangssignals Vo modulierte Referenzspannung angelegt. Das zweite Ende des Widerstandes R2 (4) ist mit dem invertierenden Eingang des Differenzintegrators verbunden. Bei dieser Schaltungsanordnung sorgt die Regelschleife dafür, daß der Mittelwert der Eingangsspannung Vmeß und der Mittelwert der mit dem Tastverhältnis des Ausgangssignals Vo modulierten Referenzspannung Vref gleich gehalten werden.

Die Werte von R1, R2, C1 und C2 gehen in die Übertragungsfunktion für den Zusammenhang zwischen Ausgangssignal und Mittelwert von Vmeß nicht ein. Vmeß und Vref haben dasselbe Vorzeichen. Außerdem hat die Schaltungsanordnung einen echten Spannungseingang Vmeß, nicht einen Spannung-zu-Stromwandler in Form von R1 wie bei der in Fig.1 gezeigten Anordnung. Als Problem bleibt weiterhin die notwendige Mittelung über 2 hoch n Perioden des Systemtakts, wenn eine Auflösung von n bit erreicht werden soll.

Die entscheidende Verbesserung wird in der erfindungsgemäßen Schaltungsanordnung entsprechend Fig.3 erreicht:

Der Ausgang des Differenzintegrators (1,2) ist an den Analogeingang C eines Pulsbreitenmodulators 11 geführt, der von einem Übertakt und einem in einem Frequenzteiler 10 aus dem Übertakt erzeugten Systemtakt gesteuert wird. Das digitale, pulsbreitenmodulierte Ausgangssignal am Ausgang Q des Pulsbreitenmodulators 11, dessen Periodendauer gleich der des Systemtakts ist und dessen Impulsdauer ein Vielfaches der Periode des Übertaktes beträgt, wird einerseits einer vom Übertakt getakteten digitalen Auswerteschaltung 12 zugeführt, andererseits steuert es zueinander komplementär den Schalter 5, bzw über einen Inverter den Schalter 50, welche beide den Rückführungseingang des Ladungsausgleichintegrators (1,2) über den Widerstand 4 alternierend an die Referenzspannung Vref, welche auch durch die Betriebsspannung der Anordnung gebildet werden kann bzw an das Bezugspotential (Masse) legen. Die Eingangsspannung des Analog-Digital-Umsetzer Vmeß wird gegebenenfalls über eine Tiefpaßfilteranordnung R1,C1 (8,9) dem nichtinvertierendem Eingang des Differenzintegrators zugeführt.

Der Operationsverstärker selbst wird bevorzugt als chopperstabilisierter Operationsverstärker ausgeführt und kann, wie in der Fig.3 angedeutet, mit nur einer Betriebsspannung VB versorgt werden.

Die Eingangsstufen des Operationsverstärkers sind bevorzugt mit Feldeffekttransistoren ausgeführt.

In einer weiteren Ausgestaltung kann der interne Choppertakt des Operationsverstärkers mit dem Übertakt beziehungsweise mit dem Systemtakf verkoppelt sein.

Der Pulsbreitenmodulator 11 kann, wie in Fig.4 gezeigt, so ausgeführt sein, daß zu Beginn jeder Periode des Systemtaktes ein D-FlipFlop 13 gesetzt und damit am Ausgang Q ein High-Pegel erzeugt wird, und gleichzeitig über einen gesteuerten Schalter 14 ein Rampenkondensator 15, welcher über eine Konstantstromquelle 16 linear aufgeladen wird rasch entladen wird; anschließend entsteht am Kondensator 15 eine bei Null beginnende, linear ansteigende Spannungsrampe; die Rampe bildet ein Sägezahnsignal.

Das Sägezahnsignal ist an den invertierenden Eingang eines Komparators 17 geführt, an dessen nichtinvertierendem Eingang C das analoge Eingangssignal des Pulsbreitenmodulators anliegt und dessen Ausgang an den D-Eingang des FlipFlops 13 geführt ist.

Da das D-FlipFlop 13 mit dem Übertakt getaktet wird, welcher dazu an seinem Takteingang anliegt, erscheint am Ausgang des FlipFlops ein Low-Pegel, sobald die Sägezahnspannung die Eingangsspannung überschritten hat und eine aktive Taktflanke des Übertakts aufgetreten ist. Die Pulsbreite am Ausgang Q des D-FlipFlops und daher am Ausgang des Pulsbreitenmodulators ist daher proportional der am Eingang C des Pulsbreitenmodulator anliegenden Spannung.

An die Linearität des Sägezahnsignals werden keine besonderen Ansprüche gestellt, da etwaige Linearitätsfehler um die Schleifenverstärkung der Regelschleife bestehend aus Differenzintegrator, Pulsbreitenmodulator und Rückführung verringert wird.

Der beschriebene Analog-Digital-Umsetzer stellt insgesamt einen Delta-Sigma Konverter erster Ordnung mit einem Analog-Digitalwandler (=Pulsbreitenmodulator) im Vorwärtszweig dar. Die theoretische Auflösung R in bit dieses Konzepts läßt sich mit etwa $R = 1.5 * \log_2 ROS + N$ zu etwa 25 bit bei einer Überabtastung ROS von 1000 (entsprechend 1000 ausgewerteten Perioden des Pulsbreitenmodulator-Signals) und einer Analog-Digital-Umsetzer Auflösung N von 10 bit (entsprechend einem Verhältnis von 1000 zwischen Übertakt und Systemtakt) im Vorwärtszweig angeben.

Die Funktion der Regelschleife ist folgende: Die Spannung am Ausgang des Operationsverstärkers 1 und damit am Eingang des Pulsbreitenmodulator 11 wird jenen Wert annehmen, der jene Pulsweite des Pulsbreitenmodulator zur Folge hat, die bestmöglichen Ladungsausgleich im Integrationskondensator 2 hervorruft.

Da die Pulsbreite quantisiert ist, kann vollkommener Ladungsausgleich nur für bestimmte Werte der Eingangsspannug erreicht werden. Die nicht ausgeglichenen Ladungsreste aus den einzelnen Perioden des Pulsbreitenmodulator 11 laden den Kondensator 2 solange um, bis der Pulsbreitenmodulator 11 die nächstgrößere oder nächstkleinere Pulsbreite (je nach Vorzeichen der Restladung) einstellt. Dadurch wird die Richtung der Ladungsänderung umgekehrt und der Pulsbreitenmodulator 11 kehrt zur ursprünglichen Pulsbreite zurück. Bei konstanter Eingangsspannung Vmeß des Analog-Digital-Umsetzer erzeugt der Pulsbreitenmodulator nur zwei benachbarte Werte der Pulsbreite, aus deren Häufigkeit die weitere, über die Auflösung des Pulsbreitenmodulator 11 hinausgehende Information gewonnen wird. Wenn zB 1000 Perioden eines 1000 schrittigen Pulsbreitenmodulator abgelaufen sind, stehen 1 Million diskreter Signalelemente zur Auswertung zur Verfügung (entsprechend einer Auflösung von 20 bit). Dieser Ablauf der 1000 Perioden mit Speicherung der Restladung kann auch als 1000-fache Überabtastung eines 10-bit Analog-Digital-Umsetzer mit entsprechender Unterdrückung des Quantisierungsgeräusches durch Verschiebung des Schwerpunktes des Störspektrums (noise shaping) verstanden werden.

Die digitale Darstellung des Resultates der A/D-Umsetzung erfolgt in der Auswerteschaltung 12 etwa durch Abzählen jener Perioden des Übertaktes, in denen das Ausgangssignal des Pulsbreitenmodulator High ist, während $10^6$ Perioden des Übertaktes oder durch digitale Tiefpaßfilterung des Ausgangssignales des Pulsbreitenmodulator. Für beide Möglichkeiten stehen Standardlösungen aus der Digitaltechnik zur Verfügung und brauchen daher nicht weiters ausgeführt werden.

Auch für die Erzeugung des Übertaktes und des aus ihm abgeleiteten Systemtaktes stellt die Digitaltechnik viele Standardlösungen bereit.

Sollen insbesonders Einstreuungen aus einem fremden taktgesteuerten System oder dem Wechselspannungs-Versorgungsnetz unterdrückt werden, so ist dies durch Verknüpfung des Systemtakts mit der Frequenz des einstreuenden Signals erreichbar.

Die Spannung am Integrationskondensator 2 bleibt bei konstanter Eingangsspannung $V_{meß}$ und unter Berücksichtigung des Sägezahnsignals, dessen Rampen von Null Volt bis $V_{ref}$ reichen, annähernd Null V, daher werden trotz der hohen Auflösung von 20 bit keine besonderen Ansprüche an den Kondensator 2 betreffend die dielektrische Absorption gestellt, was die monolithische Integration des Kondensators ermöglicht.

Der Nullpunktfehler des in Fig. 3 gezeigten Analog-Digital-Umsetzers setzt sich aus dem Nullpunktfehler des Operationsverstärkers 1 und der Summe der Schaltzeitfehler während einer Konversion zusammen. Der Beitrag des Operationsverstärkers 1 kann durch automatische Nullpunktkorrektur unter 0,5 μV gebracht werden. Es wird daher bevorzugt ein chopper stabilisierter Operationsverstärker welcher in monolothischer Technik ohne Abgleich herstellbar ist verwendet. Dieser Operationsverstärker beansprucht den überwiegenden Teil der Chipfläche der analogen Teilschaltung. Wird für ein Schaltspiel der Schalter 5 und 50 ein Zeitfehler <1 ns angenommen, so bleibt der summierte Schaltzeitfehler während 1000 Perioden des Pulsweitenmodulators 11 unter 1 μs. Das entspricht 1 LSB von 20 bit. Da die Zahl der Schaltspiele pro Konversion nicht von der Größe der Eingangsspannung des Umsetzers abhängt, verursachen die Schaltzeitfehler keinen nennenswerten Steigungsfehler. Der Steigungsfehler wird in erster Linie durch die Gleichtaktunterdrückung des Operationsverstärkers 1 bestimmt. Der Unterschied der Einschaltwiderstände der Schalter 5 und 50 verursachen einen Linearitätsfehler, dessen Größe von dem Verhältnis dieser Differenz zur Größe des Widerstandes abhängt. Um den Widerstand 4 daher groß machen zu können und gleichzeitig eine kleine Strombelastung der zu messenden Spannung $V_{meß}$ zu erreichen, werden im Operationsverstärker 1 Feldeffektransistoren als Eingangstufen verwendet. Bei ratiometrischer Verwendung des in Fig. 3 gezeigten Analog-Digital-Umsetzers ist zu beachten, daß der Innenwiderstand der Spannungsquelle $V_{ref+}$ zu den Einschaltwiderständen der Schalter 5 und 50 hinzuzuzählen sind. Es müssen daher im Falle hochohmiger Quellen Spannungsfolger verwendet werden.

Zur sicheren Erreichung einer Genauigkeit von 20 Bit sind maximale Widerstandsunsymmetrien von etwa 4 Ohm bei einem Rückführwiderstand 4 von einem Megaohm zulässig. Dies stellt für die monolithische Integration eine anspruchsvolle jedoch lösbare Forderung dar.

## Patentansprüche

1. Hochgenauer Analog-Digital-Umsetzer nach dem Ladungsausgleichverfahren mit einem Spannungseingang, einem Differenzintegrator und einer Ladungsausgleichregelschleife, **dadurch gekennzeichnet**, daß der nichtinvertierende Eingang des Differenzintegrators als Spannungseingang dient, daß im Vorwärtszweig der Regelschleife ein von einem Systemtakt gesteuerter und vom Ausgang des Differenzintegrators beaufschlagter Pulsbreitenmodulator vorgesehen ist, daß das vom Pulsbreitenmodulator erzeugte zum invertierenden Eingang des Differenzintegrators rückgeführte Signal ein systemtaktfrequentes Pulssignal ist welches als Pulsdauer ein ganzzahliges Vielfaches der Periodendauer eines Übertaktes aufweist und daß der Analog-Digital-Umsetzer zumindest im Ausmaß sämtlicher aktiver elektronischer Bauelemente monolithisch integrierbar bzw. monolithisch integriert ist.

2. Analog-Digital-Umsetzer nach Anspruch 1, **dadurch gekennzeichnet**, daß der Systemtakt aus dem Übertakt durch Frequenzteilung gewonnen wird.

3. Analog-digital-Umsetzer nach einen der Ansprüche 1 bis 2, **dadurch gekennzeichnet**, daß der Operationsverstärker des Ladungsausgleichintegrators automatischen Nullabgleich, zB. Chopperstabilisierung aufweist.

4. Analog-Digital-Umsetzer nach einem der Ansprüche 1 bis 3 **dadurch gekennzeichnet**, daß der Operationsverstärker im Ladungsausgleichintegrator Feldeffekttransistoren in der Eingangsstufe aufweist.

5. Analog-Digital-Umsetzer nach einem der Ansprüche 1 bis 4 **dadurch gekennzeichnet**, daß die Rampen des im Pulsbreitenmodulator erzeugten Sägezahnsignals den Wertebereich von Null bis zur Referenzspannung Vref des Analog-Digital-Umsetzer umfaßt.

6. Analog-Digital-Umsetzer nach einem der Ansprüche 1 bis 5 **dadurch gekennzeichnet**, daß der Analog-Digital-Umsetzer von einer einzigen Betriebsspannung versorgt wird.

**Claims**

1. High-accuracy analog-digital converter according to the charge balancing method, having a voltage input, a differential integrator and a charge balancing control loop, characterized in that the non-inverting input of the differential integrator serves as the voltage input, in that a pulse width modulator, which is controlled by a system clock and has the output of the differential integrator applied to it, is provided in the forward path of the control loop, in that the signal generated by the pulse width modulator and fed back to the inverting input of the differential integrator is a pulse signal at the system clock frequency, the pulse duration of which pulse signal is an integer multiple of the period of a higher-frequency clock, and in that the analog-digital converter is monolithically integrable or monolithically integrated at least to the extent of all the active electronic components.

2. Analog-digital converter according to Claim 1, characterized in that the system clock is obtained from the higher-frequency clock by means of frequency division.

3. Analog-digital converter according to either of Claims 1 and 2, characterized in that the operational amplifier of the charge balancing integrator has automatic zero balancing, for example chopper stabilization.

4. Analog-digital converter according to one of Claims 1 to 3, characterized in that the operational amplifier in the charge balancing integrator has field-effect transistors in the input stage.

5. Analog-digital converter according to one of Claims 1 to 4, characterized in that the ramps of the sawtooth signal generated in the pulse width modulator cover the value range from zero up to the reference voltage Vref of the analog-digital converter.

6. Analog-digital converter according to one of Claims 1 to 5, characterized in that the analog-digital converter is supplied by a single operating voltage.

**Revendications**

1. Convertisseur analogique-numérique de haute précision, travaillant selon le procédé d'égalisation de charge, avec une entrée de tension, un intégrateur différentiel et une boucle de réglage d'égalisation de charge, caractérisé par le fait que l'entrée non inverseuse de l'intégrateur différentiel sert d'entrée de tension, que, dans la branche de progression avant de la boucle de réglage, est prévu un modulateur de largeur d'impulsion, commandé par une cadence système et sollicité par la sortie de l'intégrateur différentiel, que le signal, généré par le modulateur de largeur d'impulsion et retourné à l'entrée inverseuse de l'intégrateur différentiel est un signal pulsatoire à fréquence de cadencement système qui présente, comme durée d'impulsion, un multiple entier de la durée de période d'une cadence d'ordre supérieur, et que le convertisseur analogique-numérique est susceptible d'être intégré, ou intégré de façon monolithique, au moins dans la mesure de l'ensemble des composants électroniques actifs.

2. Convertisseur analogique-numérique selon la revendication 1, caractérisé par le fait que la cadence système est obtenue, à partir de la cadence d'ordre supérieur, par une division de fréquence.

3. Convertisseur analogique-numérique selon l'une des revendications 1 et 2, caractérisé par le fait que l'amplificateur opérationnel de l'intégrateur d'égalisation de charge présente un égalisation de zéro automatique, par exemple, une stabilisation à hacheur.

4. Convertisseur analogique-numérique selon l'une des revendications 1 à 3, caractérisé par le fait que l'amplificateur opérationnel présente, dans l'intégrateur à égalisation de charge, des transistors à effet de champ montés dans l'étage d'entrée.

5. Convertisseur analogique-numérique selon l'une des revendications 1 à 4, caractérisé par le fait que les rampes du signal en dents de scie généré dans le modulateur de largeur d'impulsion couvrent la plage de valeurs allant de zéro jusqu'à la tension de référence Vref du convertisseur analogique-numérique.

6. Convertisseur analogique-numérique selon l'une des revendications 1 à 5, caractérisé par le fait que le convertisseur analogique-numérique est alimenté par une tension de fonctionnement unique.

Fig. 1

$V_0$

$\Sigma \Delta$ -Modulation

Systemtakt

$V_{ref}$

$V_{me\beta}$

Int

OP

$C_1$

$R_t$

$C_2$

$R_2$

D   Q

S

$\overline{S}$

Fig. 2

Obertakt (z.B. 1MHz)

Systemtakt (z.B. 1kHz)

10

÷1000

11

C PWM Q

1

OP

$V_B$

$C_1$

9

$R_1$

8

$V_{meß}$

2

$C_2$

12

$d_0$
$d_1$
$d_n$

1µs (Periode Übertakt)

1 ms (Periode Systemtakt)

7

$(V_B =) V_{ref}$

5

S

4

$R_2$

5D

S

Fig. 3

Fig. 4